# EUROPEAN PATENT SPECIFICATION

(11) **EP 2 958 403 B1**
(45) Date of publication and mention of the grant of the patent: **08.04.2020**
(21) Application number: 14752085.2
(22) Date of filing: 18.02.2014
(51) Int. Cl.: H05B 33/14, H01L 51/50, C09K 11/06, C09B 23/02

(54) **ELECTROLUMINESCENT FILM FOR AN OPTOELECTRONIC DEVICE**
ELEKTROLUMINSZENTER FILM FÜR EINE OPTOELEKTRONISCHE VORRICHTUNG
COUCHE ÉLECTROLUMINESCENTE POUR DISPOSITIF OPTOÉLECTRONIQUE

(30) Priority: 18.02.2013 ES 201300194
(43) Date of publication of application: 23.12.2015
(73) Proprietor: Universitat de Valéncia, 46010 Valencia (ES)
(72) Inventor: BOLINK, Hendrik Jan, E-46010 Valencia (ES); PERTEGAS OJEDA, Antonio, E-46010 Valencia (ES); TORDERA SALVADOR, Daniel, E-46010 Valencia (ES)
(74) Representative: Elzaburu S.L.P.
(86) International application number: PCT/ES2014/000023
(87) International publication number: WO 2014/125139

(56) References cited:
- GB-A- 2 356 738
- CHEN BING ET AL: "Highly efficient single-layer organic light-emitting devices using cationic iridium complex as host", ORGANIC ELECTRONICS, ELSEVIER, AMSTERDAM, NL, vol. 14, no. 3, 11 January 2013 (2013-01-11), pages 744-753, XP029002218, ISSN: 1566-1199, DOI: 10.1016/J.ORGEL.2012.12.026
- CHIEN-CHENG HO ET AL: "Phosphorescent sensitized fluorescent solid-state near-infrared light-emitting electrochemical cells", PHYSICAL CHEMISTRY CHEMICAL PHYSICS., vol. 13, 12 September 2011 (2011-09-12), pages 17729-17736, XP055276780, GB ISSN: 1463-9076, DOI: 10.1039/c1cp21861a
- XU ET AL.: 'A monolayer organic light-emitting diode using an organic dye salt' APPLIED PHYSICS LETTERS vol. 83, no. 5, 04 August 2003, pages 1020 - 1022, XP012035636 DOI: 10.1063/1.1591068
- C.C.HO ET AL.: 'Phosphorescent sensitized fluorescent solid-state near-infrared light-emitting electrochemical cells' PHYSICAL CHEMISTRY CHEMICAL PHYSICS vol. 13, 01 January 2011, pages 17729 - 17736, XP055276780 DOI: 10.1039/C1CP21861A
- B.ZHANG ET AL.: 'Photoluminiscence and electroluminescence of squarylium cyanine dyes' SYNTHETIC METALS vol. 91, no. 1-3, 01 December 1997, pages 237 - 241, XP055276787 DOI: 10.1016/S0379-6779(98)80038-6
- S.B.MEIER ET AL.: 'Dynamic doping and degradation in sandwich-type light-emitting electrochemical cells' PHYSLICAL CHEMISTRY CHEMICAL PHYSICS vol. 14, 01 January 2012, pages 10886 - 10890, XP055276794 DOI: 10.1039/C2CP41323J
- R. D. COSTA ET AL.: 'Recent advances in light-emitting electrochemical cells' PURE APPLIED CHEMISTRY vol. 83, no. 12, 2011, pages 2115 - 2128, XP055276984

## Description

### FIELD OF INVENTION

The present invention belongs to the field of light-emitting electromechanical systems, and more specifically relates to a light-emitting electrochemical cell comprising a first electrode, a second electrode electrically insulated from the first electrode and a luminescent film formed by an electroluminescent material that contains as its main component a charged dye.

### BACKGROUND OF INVENTION

In the last few decades Organic Light Emitting Diodes (OLEDs) have been the subject of considerable research as a new generation of technology with potential applications in illumination and flat screens. The interest in this technology arose from various works showing great improvements in efficiency, lifetime and colours of these devices, including white^{[1]}. However, to obtain high performance levels it is necessary to use multilayer devices. A multilayer architecture is obtained by sequentially evaporating active compounds under high vacuum conditions. In addition, these devices use metals or charge injection layers that are sensitive to air, thus requiring strict encapsulation to prevent degradation thereof^{[2]}. For OLEDs to enter the illumination market it is necessary, in addition to high performance levels, to greatly reduce the cost of the devices. In this sense it is particularly important to be able to generate electroluminescence from devices using charge injection interfaces that are stable in air.

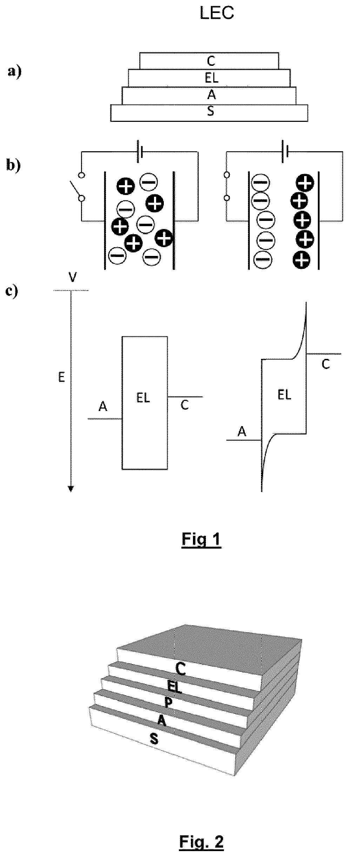

Another type of electroluminescent device, commonly known as a Light-Emitting Electrochemical Cell (LEC) has a much simpler architecture (Figure 1).

A LEC is an electroluminescent device in which the salts are (partially) dissociated into anions and cations that migrate towards the electrodes under the influence of an external electric field. As a result of this accumulation of ions at the electrodes, the injection barrier for electron and hole injection is reduced, allowing operation at a very low voltage. This is shown schematically in figure 1 of the patent application and can be inferred from figure 2, as some time must elapse for the current density and luminance to reach maximum values. This time is related to the ion migration time.

A LEC can be processed from solution and does not require the use of charge injection layers or metals that are sensitive to air in order to inject the electrons^{[3]}. This greatly simplifies the preparation and passivation, thus also greatly reducing the cost thereof. In the simplest form it consists of a single layer of active material composed by an ionic transition metal complex (iTMC) ^{[4]}. In LECs based on iTMCs the complexes fulfil all the roles necessary to generate light, namely:
a) reducing the injection barrier due to displacement of the ions;
b) transporting electrons and holes by consecutive reduction and oxidation reactions, respectively, of the iTMC, and
c) generation of photons by phosphorescence.

Interfacial fields in the electrodes shield the electric field in the volume of the material, implying that the thickness of the emitting material layer can be much higher (up to 500 nm) in LECs than in conventional OLEDs (∼100 nm) and therefore can be potentially useful in devices with fail-proof architectures. iTMCs are triplet type emitters similar to those used in OLEDs and can reach similar efficiency levels; in addition, as they are charged, they dissolve in polar solvents and are not harmful to the environment, as well as being easily processed in a thin layer. These devices are interesting candidates for use in thin layer illumination applications as they can operate at very low voltages, obtaining devices with very high energy efficiency, and are easy to manufacture.

The greatest drawback of these devices is that they use transition metal complexes, many of which are based on metals such as ruthenium, platinum or iridium^{[5]}. These are very rare metals and consequently are very expensive. Therefore, there is still a need for electroluminescent materials for optoelectronic devices such as LECs that overcome the drawbacks of the prior technology, and more specifically that allow simplifying the construction thereof by using simpler and consequently less costly materials.

### PRIOR ART

In the prior art dyes have hitherto been used in various LEC type electroluminescent devices. However, in most cases these are not ionic dyes, and in all cases known to the applicant these dyes are combined with other materials that perform the charge carrying function (electrons/holes).

CA 2 551 723 describes organic electroluminescent dyes with the general formula (Y-L)nXm, where X is an n-valence charge transporting group, Y is a light-emitting group, L is a binding group that binds the charge transporting group to the electroluminescent group, and m and n are integers not smaller than 1, able to provide electroluminescent devices that can emit light at low voltage even with a single-layer structure. However, these are neutral (non-ionic) organic dyes. Neutral dyes can only be deposited by evaporation in a vacuum and not from a solution.

H. Xu et al. (Appl. Phys. Lett., 2003, vol. 83, nº 5, pp. 1020-1022) disclosed an OLED electroluminescent device in which the electroluminescent layer is formed by an ionic organic dye, trans-4-[P-(N-ethyl-N-hydroxyethyl-amino)styryl]-N-methylpiridiniium tetraphenylborate (ASPT) salt. The authors mention that the injection barrier is reduced by the formation of a dipole in the interface caused by the polar dye. However, no mention is made of ion migration nor is any evidence shown of the movement of ions with time (LEC type behaviour), as corroborated by the high voltage required for light emission.

EP 0 554 569 A2 describes organic electroluminescent devices that comprise an electroluminescent layer containing an organic host material which can inject both holes and electrons and a fluorescent dye that can emit light in response to a hole-electron recombination. Similar devices are also described in other documents such as JP2009076817(A).

GB 2 356 738 A discloses an electroluminescent layer for a light-emitting electrochemical cell (LEC) that comprises a dye in the form of ionic salt, specifically an ionic tiophene.

In Chen Bing et al, "Highly efficient single-layer organic light-emitting devices uring cationic iridium complex as host", Organic Electronics, Vol. 14, Issue 3, March 2013, pages 744-753, single-layer OLEDs based on blended cationic iridum complexes are described.

Finally, US2005147845 A1 describes electroluminescent polymer materials including a polymer such as water-soluble polyaniline with electron/hole conductivity and an organic electroluminescent component such as cyanine dye or porphyrin in the form of J aggregates. In this document the polyaniline polymer is in a range of 50 to 90.5% by weight, while the organic electroluminescent component in the form of J aggregates is from 50% to 0.5% by weight.

However, the optoelectronic devices in accordance with the present invention do not require the combination of an ionic dye and another material to carry charges, as the ionic dyes can perform all the functions needed to generate light, namely, as indicated above:
a) reducing the injection barrier due to the displacement of the ions;
b) transporting electrons and holes by consecutive reduction and oxidation reactions, respectively, of the ionic dye; and
c) generating photons by fluorescence or phosphorescence.

Consequently, the technical problem to be solved by a person skilled in the art relates to obtaining new materials for the electroluminescent layer of optoelectronic devices, particularly LECs, which improve on the advantages of those known in the prior art and specifically which simplify the construction thereof using simpler and consequently less costly materials.

### SUMMARY OF INVENTION

The inventors have solved this problem by identifying a new class of materials that can be used satisfactorily as a single active material, or at least the main material, in the layer of electroluminescent material of the LEC since these ionic dyes can perform all the functions needed to generate light without requiring an additional material for transporting electronic charges (electrons and electron holes). These materials are ionic organic dyes, selected from cyanine, hemicyanine and squaraine dyes. These dyes have been known for years and are used in applications such as photographic film or rewritable DVDs, and have the advantage that they can be produced in large amounts at a low cost.

Moreover, the inventors have also found that, unexpectedly, addition of a small concentration (under 20%, preferably under 5% by weight of the electroluminescent layer) of a second ionic dye with an optical bandwidth smaller than that of the main ionic dye leads to a device with improved performance. Since the second dye is present in lower concentrations, it can be expected that numerous types of emitters, both fluorescent and phosphorescent, are suitable for this purpose. Regarding compatibility with the main ionic dye, the second dye is preferably also ionic, although it is also foreseeable to use neutral dyes or emitters with a high polarity.

Consequently, a first aspect of the invention relates to an electroluminescent layer for an optoelectronic device comprising at least one organic ionic dye which is present in a proportion of at least 55% by weight with respect to the total weight of the layer of electroluminescent material whereby the at least one organic ionic dye is selected from the group consisting of cyanine, hemicyanine and squaraine dyes.

### BRIEF DESCRIPTION OF DRAWINGS

Figure 1 shows a schematic representation of an LEC. An elevation view a) is shown first where S is the substrate, A is the anode, EL is the electroluminescent layer and C is the cathode. b) shows that the LEC is a single-layer or at most two-layer device containing positive and negative ions (one or both optoelectronically active) that move when an external electric field is applied. c) shows that this displacement generates and interface field allowing the efficient injection of holes and electrons from metals that can be stable in air, where V represents vacuum and E energy.
Figure 2 shows a schematic representation of the two-layer LEC device used in the first experimental example shown. The top and bottom outer layers are the aluminium cathode (C) and the In₂O₃:SnO₂ indium-tin oxide (ITO) anode (A), respectively. Between the two is arranged a layer (P) of poly(3,4-ethylenedioxythiophene):poly(styrene sulphonate) (PEDOT:PSS) in order to improve reproducibility, and next to this the electroluminescent layer (EL). A final substrate layer (S) can be added to the assembly.

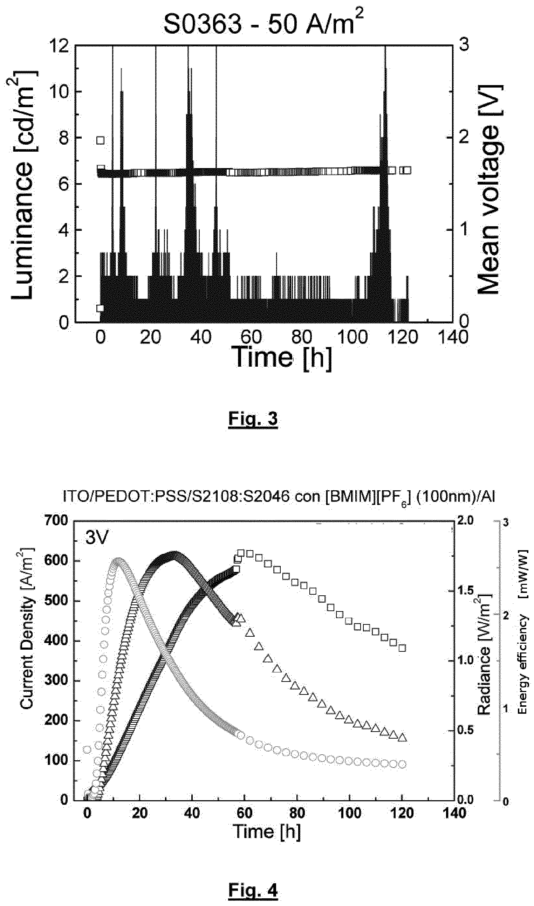

Figure 3 shows the result for luminance (solid line) and mean voltage (squares) versus time for a ITO/PEDOT:PSS/ionic dye (S0363)/Al device (with ionic liquid (IL) S0363:BMIM-PF₆[4:1]) at an applied current density of 50 A/m², obtained in Experimental Example no. 1.
Figure 4 shows the result for radiance (triangles), current density (squares) and energy efficiency (circles) versus time for a ITO/PEDOT:PSS/minority ionic dye (S2046), main ionic dye (S2108)/AI device (with ionic liquid (IL) S2108:BMIM-PF₆[4:1]) at an applied voltage of 3V, obtained in Experimental Example no. 2.

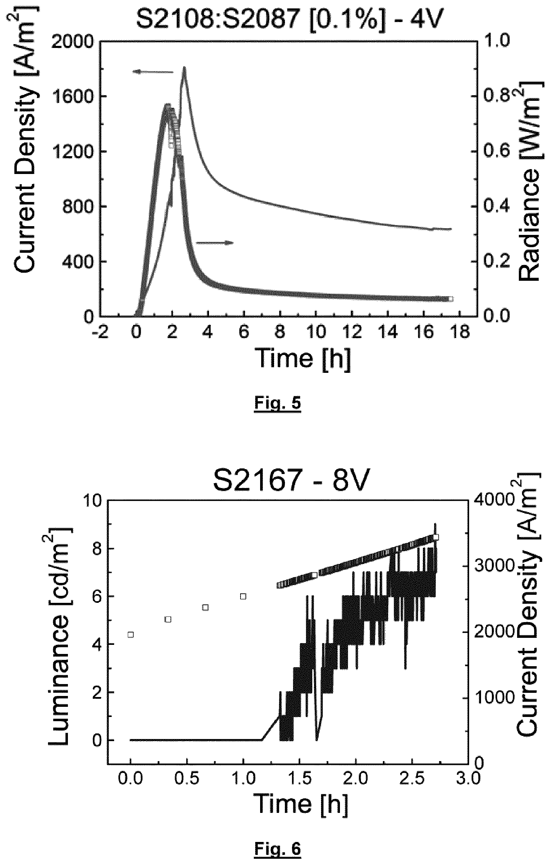

Figure 5 shows the result for radiance (squares) and current density (solid line) versus time for a ITO/PEDOT:PSS/minority ionic dye (S2087), majority ionic dye (S2108)/Al device (with ionic liquid (IL) S2108:BMIM-PF₆[4:1]) at an applied voltage of 4V, obtained in Experimental Example no. 3.
Figure 6 shows the result for luminance (solid line) and current density (squares) versus time for a ITO/PEDOT:PSS/ionic dye (S2167)/Al device (with ionic liquid (IL) S2167:BMIM-PF₆[4:1]) at an applied voltage of 8V, obtained in Experimental Example no. 4.

### DETAILED DESCRIPTION OF INVENTION

As indicated above, LECs according to the present invention essentially comprise an anode, a cathode and at least one layer of electroluminescent material between them.

The anode can be of any material capable of performing such function that is also at least partially transparent to light. One possible option is a layer of ITO, although it is also possible to use other alternative materials such as metal oxides with and without metal atom doping. It is also possible to use (grids of) carbon nanotubes, graphene, (grids of) metal nanotubes, such as copper, silver and gold deposited on glass or plastic substrates (such as polyethylene-terephthalate, PET, or polyethylene-naphthalate, PEN, polyimides, etc.). Another option is using woven fabrics with conducting wires integrated in the fabric. In anodes composed of wires or grids of wires (including woven fabrics) it is also possible to use a conducting material such as a conducting polymer to fill the spaces between the wires in order to make these conducting.

The cathode can be made of any material capable of performing such function, including those used to make the anode. Preferably, it is made of a metal with a work function under -4 eV, such as a metal aluminium layer. This is because the operation of the LECs does not depend much on the work functions of the electrodes used, which allows preparing partially transparent electroluminescent devices.

The electroluminescent material layer contains, as the main or single material, at least one organic ionic dye. This at least one dye is present in a proportion of at least 55%, more preferably at least 75%, even more preferably 80%, and even more preferably 90%, and most preferably at least 95% by weight with respect to the total weight of the electroluminescent material layer.

The organic ionic dyes are selected from the group of cyanine, hemicyanine and squaraine dyes. Some illustrative examples of dyes used in the present invention are indicated below:
- S0363, which is 3-butyl-2-[3-(1,3-dihydro-1,3,3-trimethyl-2H-indol-2-ylidine)-propenyl]-1,1-dimethyl-1H-benzo[e]indole perchlorate;
- S2108, which is 1-ethyl-2-[3-(1-ethyl-3,3-dimethyl-1,3-dihydro-indol-2-ylidine)-propenyl]-3,3-dimethyl-3H-indole hexafluorophosphate;
- S2046, which is 1-butyl-2-[5-(1-butil-1,3-dihydro-3,3-dimethyl-2H-indol-2-ylidine)-penta-1,3-dienyl]-3,3-dimethyl-3H-indole hexafluorophosphate
- S2087, which is 2-(4-(diethylamin)-2-hydroxifenyl)-4-(4-(diethyliminium)-2-hydroxi-cyclohexa-2,5-dienyliden)-3-oxocyclobut-1-enolate.
- S2167, which is 4-(7-(diethylamin)-2-oxo-2H-cromen-3-yl)-1-(3-(trimethylammonium)propyl) pyridinium dibromide.

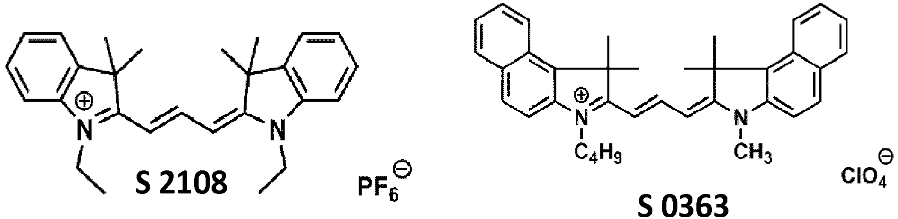

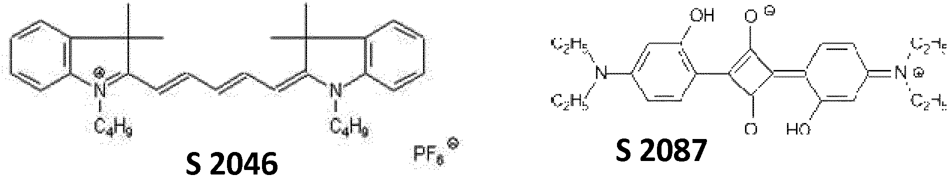

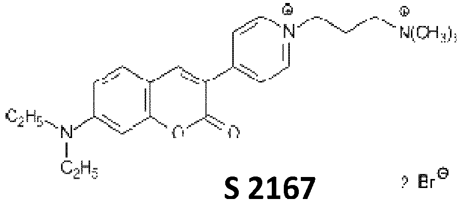

In any event, the inventors believe that many other chemical compounds, selected from cyanine, hemicyanine and squaraine ionic dyes, although not yet tested, could also be used as organic ionic dyes in the present invention, and there is no reason to believe that they could not perform this function correctly. This is the case for example with water-soluble, solvent-soluble cyanine dyes, etc.

These ionic dyes form at least part of the electroluminescent layer, either pure or mixed with an ionic liquid (IL) such as 1-butyl-3-methylimidazol hexafluorophosphate, with the chemical formula: 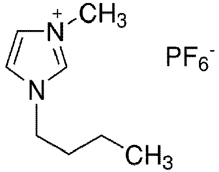 the function of which is to increase the ion concentration and favour the generation of an ionic layer in the interfaces with electrodes and thereby the injection of electrons and holes, and subsequently the device start-up. If present, this ionic liquid is present in the electroluminescent layer in a proportion under 45% by weight, more preferably under 25% by weight, even more preferably under 10% by weight and most preferably in a proportion under 5% by weight, with respect to the total weight of the electroluminescent layer.

Preferably, together with the layer of electroluminescent material it is possible to add a layer meant to improve the reproducibility of the device. In preferred embodiments of the invention, this layer was made from a conducting polymer such as poly(3,4-ethylenedioxythiophene):poly(styrene sulfonate) (PEDOT:PSS), although other alternative materials can also be used such as metal oxides with and without doping of other metal atoms, or conjugated molecules and polymers such as polyarylamines, polythiophenes, polyfluorenes, polyphenylenevinylenes, polypyrroles, etc.

In other embodiments, the electroluminescent layer also comprises at least one additional molecular emitter. By "molecular emitter" is understood in general a molecular material that emits light when excited by absorption of light. Illustrative examples of these molecular emitters are, among others, organic molecules and organo-metallic complexes of transition metals, and can be neutral or ionic molecules. In preferred embodiments, the additional emitter or emitters are present in the electroluminescent layer at an overall concentration under 20%, preferably under 10%, and even more preferably under 5% by weight with respect to the total weight of the electroluminescent layer. Since the additional molecular emitter is present in lower concentrations than the main ionic organic dye, it is expected that many types of emitters, both fluorescent and phosphorescent, work for this purpose. Regarding compatibility with the main ionic dye, the additional molecular emitter is preferably also an ionic dye, albeit a different one from the main ionic dye. In more preferred embodiments, the molecular emitter is an ionic dye that has an optical bandwidth smaller than that of the main ionic dye. Alternatively, it is also foreseeable that other types of dyes can be used for this purpose, such as neutral dyes or high-polarity emitters.

Finally, the assembly of the anode + cathode + electroluminescent material layer between them, as well as the layer of material adjoining the layer of electroluminescent material meant to improve the reproducibility of the device when present, are preferably arranged, to improve handling thereof, on a layer of a substrate material. This substrate layer is preferably made of glass, although other materials can alternatively be used such as plastics, woven fabrics, etc. This allows building a luminescent optoelectronic device with substantially improved performance with respect to those known in the prior art. This device can advantageously be a light-emitting electrochemical cell (LEC).

The invention will be illustrated below on the basis of the following Experimental Examples, which in no way should be considered to limit the invention.

### EXPERIMENTAL EXAMPLES

### Example no. 1

In the experiment shown below a two-layer LEC was used (figure 2). The top and bottom outermost layers are the aluminium cathode (C) and the ITO anode (A) respectively. Between these is arranged a layer of about 100 nm approximately of PEDOT:PSS (P) to homogenise the transparent conducting electrode, while the second layer of approximately 80 nm is the electroluminescent layer (EL). All of these layers are supported by a final substrate layer of glass (S).

This electroluminescent device was manufactured as follows:
- To the glass substrate (S) was applied a layer of indium oxide and tin by a cathode spray technique and structuring using photolithography to generate the pattern of the ITO that acts as an anode (A);
- The substrate was washed very carefully by sonication in a water bath with soap, water and isopropanol, and then cleaned introducing it in an ozone-producing UV lamp for 20 minutes;
- Then, on the ITO layer (A) a layer of PEDOT:PSS (P) was applied with 90 nanometre thickness using the spin-coating technique, which involves applying the solution through a filter onto the substrate and spinning it at a high speed (from 500 to 5000 revolutions per minute);
- Then the active layer of electroluminescent material (EL) was obtained, also about 80 nanometres in thickness, and also by the spin-coating technique. This layer consisted of the ionic dye S0363 dissolved in acetonitrile to which is added the ionic liquid 1-butyl-3-methylimidazole hexafluorophosphate in a 4:1 molar ration with respect to the ionic dye S0363;
- Finally, using high-vacuum thermal vapour deposition, the aluminium layer of about 70 nanometres in thickness was applied, acting as the cathode (C).

The results, shown in figure 3, indicate that a certain amount of light emission was observed, although not very high. This is possibly due to partial auto-deactivation of the excitons by the molecules of the active component S0363.

### Example no. 2

This experimental example was performed on the same LEC device of Example 1 prepared with the same manufacturing method, although in this case for the EL layer a dye with narrow bandwidth (S2046, minority component, 0.5%) was mixed with a dye with a greater bandwidth (S2108, main component, 99.5%), to which was added the ionic liquid 1-butyl-3-methylimidazole hexafluorophosphate in a 4:1 molar ratio with respect to the main ionic dye.

The results are represented in figure 4, which shows that radiance, efficiency and half-life of the device were highly satisfactory, even greater than those obtained when using a single active component. It is believed that the reason for this result is that, in this configuration, the excitons are not deactivated, significantly increasing radiance.

### Example no. 3

This experimental example was performed on the same LEC device of Example 2 prepared with the same manufacturing method, although in this case for the EL layer a dye with narrow bandwidth (S2087, a squaraine type dye, minority component, 0.5%) was mixed with a dye with a greater bandwidth (S2108, main component, 99.5 to which was added the ionic liquid 1-butyl-3-methylimidazole hexafluorophosphate in a 4:1 molar ratio with respect to the main ionic dye.

The results are represented in figure 5, which shows that radiance, efficiency and half-life of the device were highly satisfactory. It is believed that the reason for this result is that, in this configuration, the excitons are not deactivated, significantly increasing radiance.

### Example no. 4

This experimental example was performed on the same LEC device of Example 1 prepared with the same manufacturing method, although in this case for the EL layer the cyanine dye (S2167) was used, to which was added the ionic liquid 1-butyl-3-methylimidazole hexafluorophosphate in a 4:1 molar ratio with respect to the ionic dye S2167.

The results, shown in figure 6, indicate that the emission of a certain amount of light was observed, although not a very great amount. This is possibly due to partial auto-deactivation of the excitons by the own molecules of the active component S2167.

### Bibliography

[1] Y. Sun, N. C. Giebink, H. Kanno, B. Ma, M. E. Thompson, S. R. Forrest, Nature 2006, 440, 908.
[2] K. Walzer, B. Maennig, M. Pfeiffer, K. Leo, Chem. Rev. 2007, 107, 1233*.*
[3] Q. Pei, G. Yu, C. Zhang, Y. Yang, A. J. Heeger, Science 1995, 269, 1086.
[4] J. D. Slinker, J. Rivnay, J. S. Moskowitz, J. B. Parker, S. Bernhard, H. D. Abruña, G. G. Malliaras, J. Mat. Chem. 2007, 17, 2976.
[5] R. D. Costa, E. Orti, H. J. Bolink, F. Monti, G. Accorsi, N. Armaroli, Angew. Chem. Int. Ed. 2012, 51, 8178.

## Claims

1. Electroluminescent layer for a light-emitting electrochemical cell (LEC) that comprises at least one organic ionic dye which is present in a proportion of at least 55% by weight with respect to the total weight of the layer of electroluminescent material, **characterised in that** the at least one organic ionic dye is selected from the group consisting of cyanine hemicyanine and squaraine dyes.

2. Electroluminescent layer according to claim 1, wherein the at least one organic ionic dye is present in a proportion of at least 75% by weight with respect to the total weight of the layer of electroluminescent material.

3. Electroluminescent layer according to claim 2, wherein the at least one organic ionic dye is present in a proportion of at least 90% by weight with respect to the total weight of the layer of electroluminescent material.

4. Electroluminescent layer according to any of the preceding claims, further comprising at least one additional molecular emitter with an optical bandwidth smaller than that of the main organic ionic dye.

5. Electroluminescent layer according to claim 4, wherein the at least one additional molecular emitter is present in an overall proportion equal to or less than 20% by weight with respect to the weight of the electroluminescent layer.

6. Electroluminescent layer according to claims 4 or 5, wherein the at least one additional molecular emitter is an organic ionic dye different from the main organic ionic dye.

7. Electroluminescent layer according to claims 4 or 5, wherein the at least one additional molecular emitter is a neutral organic dye or an emitter with a high polarity.

8. Electroluminescent layer according to any of the preceding claims, further comprising an ionic liquid.

9. Electroluminescent layer according to the preceding claim 8, wherein the ionic liquid is present in a proportion of 5% by weight with respect to the total weight of the layer of electroluminescent material.

10. Light-emitting electrochemical cell (LEC) that comprises a layer of electroluminescent material according to any one of the preceding claims and an anode and cathode, between which the layer of electroluminescent material is located.

11. Light-emitting electrochemical cell (LEC) according to claim 10, wherein the anode is made of a conducting material at least partially transparent to light.

12. Light-emitting electrochemical cell (LEC) according to any one of claims 10-11, wherein the cathode is made of a metal with a work function under -4 eV.

13. Light-emitting electrochemical cell (LEC) according to any one of claims 10-12, which further comprises a layer of a conducting polymer adjacent to the layer of electroluminescent material.

## Patentansprüche

1. Elektrolumineszenzschicht für eine lichtemittierende elektrochemische Zelle (LEC), die mindestens einen organischen ionischen Farbstoff umfasst, der in einem Anteil von mindestens 55 % nach Gewicht, bezogen auf das Gesamtgewicht der Schicht aus Elektrolumineszenzmaterial, vorhanden ist, **dadurch gekennzeichnet, dass** der mindestens eine organische ionische Farbstoff aus einer Gruppe ausgewählt wird, die aus Cyanin-, Hemicyanin- und Squarainfarbstoffen besteht.

2. Elektrolumineszenzschicht nach Anspruch 1, wobei der mindestens eine organische ionische Farbstoff in einem Anteil von mindestens 75 % nach Gewicht, bezogen auf das Gesamtgewicht der Schicht aus Elektrolumineszenzmaterial, vorhanden ist.

3. Elektrolumineszenzschicht nach Anspruch 2, wobei der mindestens eine organische ionische Farbstoff in einem Anteil von mindestens 90 % nach Gewicht, bezogen auf das Gesamtgewicht der Schicht aus Elektrolumineszenzmaterial, vorhanden ist.

4. Elektrolumineszenzschicht nach einem der vorhergehenden Ansprüche, ferner umfassend mindestens einen zusätzlichen molekularen Emitter mit einer optischen Bandbreite, die kleiner ist als die des organischen ionischen Hauptfarbstoffs.

5. Elektrolumineszenzschicht nach Anspruch 4, wobei der mindestens eine zusätzliche molekulare Emitter in einem Gesamtanteil von gleich oder weniger als 20 % nach Gewicht, bezogen auf das Gesamtgewicht der Elektrolumineszenzschicht, vorhanden ist.

6. Elektrolumineszenzschicht nach Anspruch 4 oder 5, wobei der mindestens eine zusätzliche molekulare Emitter ein organischer ionischer Farbstoff ist, der sich von dem organischen ionischen Hauptfarbstoff unterscheidet.

7. Elektrolumineszenzschicht nach Anspruch 4 oder 5, wobei der mindestens eine zusätzliche molekulare Emitter ein neutraler organischer Farbstoff oder ein Emitter mit hoher Polarität ist.

8. Elektrolumineszenzschicht nach einem der vorhergehenden Ansprüche, ferner umfassend eine ionische Flüssigkeit.

9. Elektrolumineszenzschicht nach dem vorherigen Anspruch 8, wobei die ionische Flüssigkeit in einem Anteil von 5 % nach Gewicht, bezogen auf das Gesamtgewicht der Schicht aus Elektrolumineszenzmaterial, vorhanden ist.

10. Lichtemittierende elektrochemische Zelle (LEC), die eine Schicht aus Elektrolumineszenzmaterial nach einem der vorhergehenden Ansprüche umfasst sowie eine Anode und eine Kathode, zwischen denen sich die Schicht aus Elektrolumineszenzmaterial befindet.

11. Lichtemittierende elektrochemische Zelle (LEC) nach Anspruch 10, wobei die Anode aus einem leitenden Material hergestellt ist, das zumindest teilweise für Licht transparent ist.

12. Lichtemittierende elektrochemische Zelle (LEC) nach einem der Ansprüche 10 bis 11, wobei die Kathode aus einem Metall mit einer Austrittsarbeit unter -4 eV hergestellt ist.

13. Lichtemittierende elektrochemische Zelle (LEC) nach einem der Ansprüche 10 bis 12, die ferner eine Schicht aus einem leitenden Polymer benachbart zu der Schicht aus Elektrolumineszenzmaterial umfasst.

## Revendications

1. Couche électroluminescente pour cellule électrochimique électroluminescente (LEC) qui comprend au moins un colorant ionique organique qui est présent dans une proportion d'au moins 55 % en poids par rapport au poids total de la couche de matériau électroluminescent, **caractérisé en ce que** le au moins un colorant organique ionique est choisi du groupe comportant des colorants de cyanine, d'hémicyanine et Squaraine.

2. Couche électroluminescente en fonction de la revendication 1, dans laquelle le au moins un colorant organique ionique est présent dans une proportion d'au moins 75 % en poids par rapport au poids total de la couche de matériau électroluminescent.

3. Couche électroluminescente en fonction de la revendication 2, dans laquelle le au moins un colorant organique ionique est présent dans une proportion d'au moins 90 % en poids par rapport au poids total de la couche de matériau électroluminescent.

4. Couche électroluminescente en fonction de l'une des revendications précédentes, comprenant en outre au moins un émetteur moléculaire supplémentaire avec une largeur de bande optique inférieure à celle du colorant organique ionique principal.

5. Couche électroluminescente en fonction de la revendication 4, dans laquelle le au moins un émetteur moléculaire supplémentaire est présent dans une proportion globale égale ou inférieure à 20 % en poids par rapport au poids de la couche électroluminescente.

6. Couche électroluminescente en fonction des revendications 4 ou 5, dans laquelle le au moins un émetteur moléculaire supplémentaire est un colorant ionique organique différent du colorant ionique organique principal.

7. Couche électroluminescente en fonction des revendications 4 ou 5, dans laquelle le au moins un émetteur moléculaire supplémentaire est un colorant organique neutre ou un émetteur à haute polarité.

8. Couche électroluminescente en fonction de l'une des revendications précédentes, comprenant en outre un liquide ionique.

9. Couche électroluminescente en fonction de la revendication précédente 8, dans laquelle le liquide ionique est présent dans une proportion de 5 % en poids par rapport au poids total de la couche de matériau électroluminescent.

10. Cellule électrochimique électroluminescente (LEC) qui comprend une couche de matériau électroluminescent en fonction de l'une des revendications précédentes, et une anode et une cathode, entre lesquelles se trouve la couche de matériau électroluminescent.

11. Cellule électrochimique électroluminescente (LEC) en fonction de la revendication 10, dans laquelle l'anode est constituée d'un matériau conducteur au moins partiellement transparent à la lumière.

12. Cellule électrochimique électroluminescente (LEC) en fonction de l'une des revendications 10-11, dans laquelle la cathode est constituée d'un métal avec un travail d'extraction inférieur à -4 eV.

13. Cellule électrochimique électroluminescente (LEC) en fonction de l'une des revendications 10-12, qui comprend en outre une couche d'un polymère conducteur adjacente à la couche de matériau électroluminescent.
